# EUROPÄISCHE PATENTSCHRIFT

(11) **EP 1 759 426 B1**
(45) Veröffentlichungstag und Bekanntmachung des Hinweises auf die Patenterteilung: **28.11.2007**
(21) Anmeldenummer: 05760044.7
(22) Anmeldetag: 13.06.2005
(51) Int. Cl.: H01L 39/16, H02H 9/02

(54) **STROMBEGRENZUNGSEINRICHTUNG MIT SUPRALEITENDEM SCHALTELEMENT**
CURRENT LIMITING DEVICE HAVING A SUPERCONDUCTIVE SWITCHING ELEMENT
LIMITEUR DE COURANT A ELEMENT DE COMMUTATION SUPRACONDUCTEUR

(30) Priorität: 24.06.2004 DE 102004031908
(43) Veröffentlichungstag der Anmeldung: 07.03.2007
(73) Patentinhaber: SIEMENS AKTIENGESELLSCHAFT, 80333 München (DE)
(72) Erfinder: KRÜGER, Ursus, 14089 Berlin (DE); VOLKMAR, Ralf-Reiner, 13353 Berlin (DE)
(86) Internationale Anmeldenummer: PCT/DE2005/001089
(87) Internationale Veröffentlichungsnummer: WO 2006/000185

(56) Entgegenhaltungen:
- DE-A1- 10 230 084
- DE-A1- 10 230 618
- SHIMIZU H ET AL: "A study on required volume of superconducting element for flux flow resistance type fault current limiter" IEEE TRANSACTIONS ON APPLIED SUPERCONDUCTIVITY IEEE USA, Bd. 13, Nr. 2, Juni 2003 (2003-06), Seiten 2052-2055, XP002348609 ISSN: 1051-8223
- ARITAKE T ET AL: "Relation between critical current density and flux flow resistivity in Bi2223 bulk element for fault current limiter" IEEE TRANSACTIONS ON APPLIED SUPERCONDUCTIVITY IEEE USA, Bd. 13, Nr. 2, Juni 2003 (2003-06), Seiten 2084-2087, XP002348627 ISSN: 1051-8223
- WELLER R A ET AL: "Computer modelling of superconducting film type fault current limiters" IEEE TRANSACTIONS ON APPLIED SUPERCONDUCTIVITY IEEE USA, Bd. 9, Nr. 2, Juni 1999 (1999-06), Seiten 1377-1380, XP002348610 ISSN: 1051-8223
- MATSUMURA T ET AL: "Performances of small fault current limiting breaker model with high Tc Superconductor" IEEE TRANSACTIONS ON APPLIED SUPERCONDUCTIVITY IEEE USA, Bd. 15, Nr. 2, Juni 2005 (2005-06), Seiten 2114-2117, XP002348608 ISSN: 1051-8223

## Beschreibung

Die Erfindung betrifft eine elektrische Strombegrenzungseinrichtung mit einem in einem Kryostaten angeordneten supraleitenden Schaltelement.

Eine Strombegrenzungseinrichtung der eingangs genannten Art ist beispielsweise aus der DE 102 30 084 A1 bekannt. Diese Strombegrenzungseinrichtung wird in einem elektrischen Netz betrieben. Der Strom wird über das supraleitende Schaltelement geführt, welches bei der durch ständige Kühlung gehaltenen Betriebstemperatur einen vernachlässigbar geringen elektrischen Widerstand aufweist. Tritt in dem Netz ein Netzfehler (beispielsweise ein Kurzschluss) auf, so bewirkt der unzulässig hohe Kurzschlussstrom in dem supraleitenden Schaltelement ein Verhalten, welches als Quenchen bezeichnet wird. Der hohe Stromfluss erzeugt im Supraleiter eine Induktion, die dessen elektrischen Widerstand zunächst geringfügig erhöht. Hierdurch gerät der Supraleiter in den so genannten Flux-Flow-Bereich, in dem das supraleitende Material in der Shubnikov-Phase vorliegt. Dieses Verhalten ist beispielsweise in W. Buckel, Supraleitung: Grundlagen und Anwendungen, Weinheim 1990 beschrieben. Danach bilden sich in der Shubnikov-Phase im supraleitenden Material zeitgleich normal- und supraleitende Bereiche aus, die durch wandernde, normal leitende Flussschläuche im Supraleiter gebildet werden. Die damit verbundene Widerstandserhöhung des supraleitenden Schaltelementes führt zu einer Erwärmung des Supraleiters. Diese kann noch beschleunigt werden, wenn, wie allgemein üblich, ein Kommutierungsleiter als Schicht auf dem Supraleiter aufgebracht ist, der bei Eintreten des Supraleiters in den Flux-Flow-Bereich einen Teil des Kurzschlussstromes übernimmt und aufgrund seines wesentlich höheren Widerstandes zusätzliche Wärme erzeugt. Die Erwärmung des Schaltelementes führt in kürzester Zeit dazu, dass eine kritische Temperatur überschritten wird, oberhalb derer der Supraleiter normalleitend ist, also temperaturbedingt den Flux-Flow-Bereich verlässt und aufgrund seines sprunghaft ansteigenden, nun ohmschen Widerstandes den Kurzschlussstrom auf einen Kurzschlussreststrom begrenzt.

Um eine Beschädigung des supraleitenden Schaltelementes im Strombegrenzungsfall zu vermeiden, muss das Schaltelement spätestens 50 ms nach dem Ansprechen wieder entlastet werden, was beispielsweise mittels eines elektrischen Bypasselementes erfolgt, welches aufgrund seines Widerstandes die Strombegrenzung bewirkt. Das supraleitende Schaltelement wird vom Netz getrennt und ist erst wieder einsatzfähig, wenn es auf die ursprüngliche Betriebstemperatur zurückgekühlt wurde.

Aus der DE 102 30 618 A1 ist ein Aufbau für einen supraleitenden Strombegrenzer beschrieben, der mittels eines bandförmigen Aufbaus des Supraleiters erreicht wird. Der bandförmige Supraleiter ist spiralförmig in dem Kühlmittel angeordnet, derart, dass zwischen den Spiralwindungen das Kühlmittel die Oberfläche des Supraleiters erreichen kann. Hierdurch lässt sich die Abkühlzeit nach einem Strombegrenzungsfall verkürzen, so dass die Strombegrenzungseinrichtung nach dem Strombegrenzungsfall verhältnismäßig schnell wieder zum Einsatz kommen kann. Jedoch ist aufgrund des beschriebenen Funktionsprinzips eine Kühlung vor einem neuen Einsatz des Strombegrenzers nötig.

Aus H. Shimizu et al., IEEE Trans. Appl. Supercond. 13 (2003), 2052-5, ist eine Strombegrenzungseinrichtung mit einem supraleitenden Element bekannt, wobei das Schaltelement bei Erreichen des geforderten Kurzschlussreststromes in der Shubnikov-Phase vorliegt.

Die Aufgabe der Erfindung besteht darin, eine elektrische Strombegrenzungseinrichtung mit einem supraleitenden Schaltelement anzugeben, welches im Strombegrenzungsfall uneingeschränkt zur Strombegrenzung zur Verfügung steht und nach einem Strombegrenzungsfall sofort wieder einsatzbereit ist.

Diese Aufgabe wird erfindungsgemäß dadurch gelöst, dass das Schaltelement derart dimensioniert ist, dass es im Strombegrenzungsfall bei Erreichen des geforderten Kurzschlussstromes der Strombegrenzungseinrichtung in der Shubnikov-Phase vorliegt. Erfindungsgemäß muss das supraleitende Schaltelement also so ausgelegt werden, dass die im Vergleich zum Quenchen des Supraleiters nur geringfügige Erhöhung des elektrischen Widerstandes beim Betrieb im Flux-Flow-Bereich (d. h. Vorliegen des Supraleiters in der Shubnikov-Phase) ausreicht, um eine Begrenzung des Kurzschlussstroms auf den Kurzschlussreststrom zu bewirken. Dies wird erreicht, indem das supraleitende Schaltelement eine genügende Leiterlänge aufweist, um den für den geforderten Kurzschlussreststrom notwenigen Widerstand bereits beim Vorliegen in der Shubnikov-Phase bei einer Temperatur zu erreichen, die einen genügenden Sicherheitsabstand zur kritischen Temperatur (Übergang in den normal leitenden Zustand) aufweist. Das supraleitende Schaltelement kann insbesondere als Bandleiter ausgeführt werden, da sich auf diese Weise die geforderte Leiterlänge kostengünstig herstellen lässt.

Bei dem Betreib des supraleitenden Schaltelementes im Flux-Flow-Bereich erwärmt sich das supraleitende Schaltelement anders als beim Quenchen nur um einen verhältnismäßig geringen Betrag von wenigen Kelvin. Daher kann die entstehende Wärme durch den zur Kühlung des Schaltelementes vorgesehenen Kryostaten zuverlässig abgeführt werden, was zusätzlich dadurch begünstigt wird, dass der Bandleiter eine vergleichsweise große Fläche für den Wärmeübergang zur Verfügung stellt. Es ist daher möglich, durch geeignete Dimensionierung der Strombegrenzungseinrichtung im Strombegrenzungsfall ein thermisches Gleichgewicht zwischen der durch den Kurzschlussreststrom erzeugten Wärme und der durch das Kühlmittel abgeführten Wärme zu gewährleisten, so dass das supraleitende Schaltelement in einem stabilen Zustand betrieben wird. Somit kann das supraleitende Schaltelement auch über einen längeren Zeitraum den Strom begrenzen, ohne dass seine Entlastung beispielsweise durch ein Bypasselement notwendig wird. Außerdem kann zusätzlich vorteilhaft die Rückkühlung um wenige Kelvin in kürzester Zeit erfolgen, so dass das supraleitende Schaltelement nach einem Strombegrenzungsfall sofort wieder einsatzbereit ist.

Gemäß einer Ausgestaltung der Erfindung ist vorgesehen, dass die Kühlleistung des Kryostaten derart dimensioniert ist, dass das Schaltelement während der gesamten Strombegrenzungszeit in einem Temperaturbereich gehalten werden kann, in dem dieser in der Shubnikov-Phase vorliegt. Damit lässt sich mit der Strombegrenzungseinrichtung ein Betriebsregime realisieren, bei dem das supraleitende Schaltelement immer im Netz ist und so seine Funktion uneingeschränkt zur Verfügung stellt. Dies bedeutet vorteilhaft einen Sicherheitsgewinn, weil z. B. auch in kurzer Zeitfolge hintereinander auftretende Netzfehler jeweils einen Strombegrenzungsfall in der Strombegrenzungseinrichtung auslösen können. Ein weiterer Vorteil liegt darin, dass das supraleitende Schaltelement beim Betrieb während des Strombegrenzungsfalles im Flux-Flow-Bereich vollständig reversibel zwischen supraleitender Phase und Shubnikov-Phase wechseln kann, wobei eine Beschädigung des Supraleitermaterials ausgeschlossen ist.

Gemäß einer Variante der Erfindung ist vorgesehen, dass das Schaltelement mit einer thermischen Isolationsschicht versehen ist. Hierdurch lässt sich vorteilhaft der Wärmeübergang zwischen dem supraleitenden Schaltelement und dem Kühlmittel des Kryostaten direkt beeinflussen, so dass eine geeignete Auslegung der Strombegrenzungseinrichtung im Bezug auf die Ausbildung des thermischen Gleichgewichtes im Strombegrenzungsfall möglich ist. Eine thermische Isolierung des supraleitenden Schaltelementes bewirkt nämlich, dass eine Wärmeabgabe an das Kühlmittel des Kryostaten verzögert wird, so dass sich das supraleitende Schaltelement stärker erwärmt, womit sich auch der Widerstand erhöht. Selbstverständlich darf trotz der thermischen Isolierung keine Erwärmung bis zur kritischen Temperatur erfolgen.

Gemäß einer anderen Variante der Erfindung trägt das Schaltelement einen Kommutierungsleiter der parallel zum Schaltelement verläuft. Der Kommutierungsleiter und das Schaltelement können beispielsweise einen Schichtverbund bilden, wobei die Schichten des Schaltelementes und des Kommutierungsleiters aufeinander folgen, d. h. innig miteinander verbunden sind. Der Kommutierungsleiter vergrößert vorteilhaft die Sicherheit gegen ein örtliches Quenchen des Schaltelementes und übernimmt außerdem im Strombegrenzungsfall einen gewissen Anteil des Kurzschlussreststromes, der von dem Verhältnis der elektrischen Widerstände des sich in der Shubnikov-Phase befindenden Schaltelementes und des Kommutierungsleiters abhängig ist.

Es ist vorteilhaft, wenn der Kommutierungsleiter aus einem Metall oder einer Metalllegierung mit positiver magnetischer Suszeptibilität gebildet ist. Hierdurch wird die magnetische Induktion (B) im Schichtverbund aus Schaltelement und Kommutierungsleiter erhöht, sobald der Kommutierungsleiter von einem Magnetfeld durchdrungen wird. Dies ist z. B. der Fall. Wenn der Kommutierungsleiter im Strombegrenzungsfall an der Stromführung beteiligt wird.

Weiterhin ist es vorteilhaft, wenn das Schaltelement spiralförmig im Kryostaten verläuft. Auf diese Weise lässt sich vorteilhaft die erforderliche Länge des Schaltelementes platzsparend unterbringen, wobei der spiralförmige Verlauf dem Kühlmittel des Kryostaten zwischen jeweils benachbarten Windungen genügend Platz lässt, um einen direkten Wärmeübergang vom Schaltelement zum Kühlmittel zu gewährleisten.

Gemäß einer zusätzlichen Variante der Erfindung kann vorgesehen werden, dass in Parallelschaltung zum Schaltelement ein Bypasselement angeordnet ist. Dieses ist in seinem elektrischen Widerstand derart dimensioniert, dass ein bestimmter Teil des Kurzschlussstromes über das Bypasselement fließt, wodurch das Schaltelement und eventuell der Kommutierungsleiter entlastet werden.

Es ist vorteilhaft, wenn sich das Bypasselement außerhalb des Kryostaten befindet. Damit entsteht ein Teil der durch den Strombegrenzungsvorgang erzeugten Wärme in dem Bypasselement und damit außerhalb des Kryostaten, so dass dessen Kühlkapazität für das supraleitende Schaltelement in jedem Falle ausreicht. Anders als in bekannten Strombegrenzungseinrichtungen wird das Bypasselement jedoch während der ganzen Strombegrenzungszeit parallel zum Schaltelement betrieben, d. h. das Schaltelement bliebt am Netz.

Weitere Einzelheiten der Erfindung werden im Folgenden anhand der Zeichnung beschrieben. Hierbei zeigen
- Figur 1: den stark schematisierten Aufbau eines Ausführungsbeispiels der erfindungsgemäßen Strombegrenzungseinrichtung,
- Figur 2: den Querschnitt durch ein Ausführungsbeispiel des supraleitenden Schaltelements und
- Figur 3: Widerstand und magnetische Feldstärke der Komponenten eines Ausführungsbeispiels der erfindungsgemäßen Strombegrenzungseinrichtung in Abhängigkeit von der Temperatur.

Eine Strombegrenzungseinrichtung 11 weist zwei Anschlusselemente 12 auf, mit denen diese in ein elektrisches Netz eingebunden werden kann. Die Strombegrenzungseinrichtung 11 besteht im Wesentlichen aus einem supraleitenden Schaltelement 13 und einem Bypasselement 14, welches parallel zum Schaltelement 13 angeordnet ist. Das Schaltelement 13 ist in einem Kryostaten 15 untergebracht, welcher zu diesem Zweck einen mit flüssigem Stickstoff als Kühlmittel 16 gefüllten Isolierbehälter 17 aufweist. Ein Kühlkopf 18 führt die Wärme aus dem Isolierbehälter ab. Weiterhin sind an dem Isolierbehälter 17 Leitungszuführungen 19 vorgesehen, welche eine elektrische Kontaktierung 11 des Schaltelementes 13 mit den außerhalb des Isolierbehälters 17 liegenden Anschlusselementen 12 erlauben.

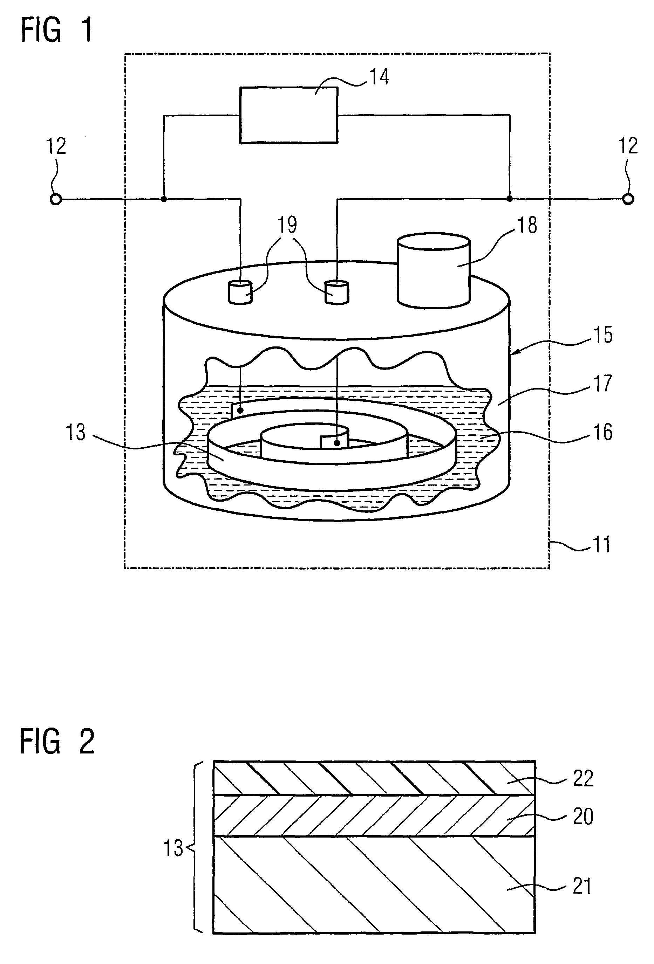

Das supraleitende Schaltelement 13 ist in Figur 2 im Schnitt dargestellt. Es besteht aus einem Schichtverbund, wobei eine supraleitende Schicht 20 (beispielsweise YBCO) auf einem Kommuntierungsleiter 21 durch Beschichten hergestellt wird.

Auf der supraleitenden Schicht 20 ist weiterhin eine thermische Isolationsschicht 22 beispielsweise aus Kunststoff aufgebracht. Zwischen der supraleitenden Schicht 20 und der Kommutierungsschicht 21 können weiter für die Herstellung der supraleitenden Schicht 20 wichtige Schichten, z. B. eine Pufferschicht vorgesehen werden (nicht näher dargestellt).

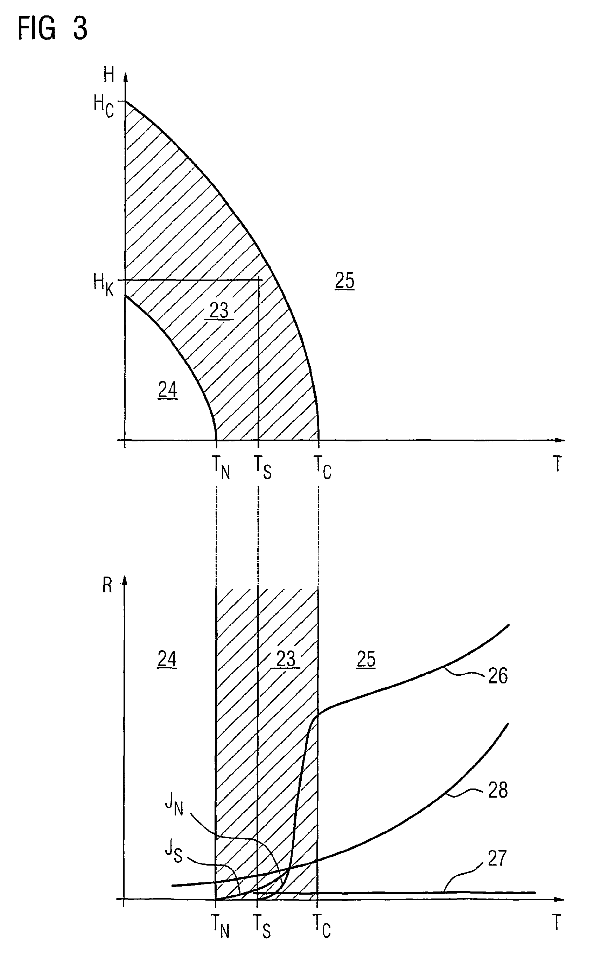

Der Figur 3 kann entnommen werden, in welchen Phasenzuständen sich das supraleitende Schaltelement befinden kann. Die Shubnikov-Phase 23, in der das supraleitende Schaltelement im Flux-Flow-Bereich betrieben werden kann, ist schraffiert dargestellt. Jeweils links davon liegt die supraleitende Phase 24, in der das Schaltelement einen vernachlässigbar geringen elektrischen Widerstand aufweist; rechts davon liegt der normalleitende Bereich 25, in dem sich das Schaltelement wie ein ohmscher Widerstand verhält. Im normalleitenden Bereich 25 soll das erfindungsgemäße Schaltelement nicht betrieben werden.

In dem oberen der Diagramme zeigt sich, dass das Vorliegen der Shubnikov-Phase 23 sowohl von der Temperatur T als auch von der in dem Schaltelement vorliegenden magnetischen Feldstärke H abhängig ist. Oberhalb einer kritischen Feldstärke H_{C} und einer kritischen Temperatur T_{C} liegt der Supraleiter immer in der normalleitenden Phase 25 vor. Unterhalb von T_{C} und H_{C} gilt die Beziehung, dass bei steigender magnetischer Feldstärke die kritische Temperatur T_{C(H)} bzw. bei steigender Temperatur die kritische magnetische Feldstärke H_{C(T)} entsprechend verringert wird.

Im unteren der Diagramme ist der Widerstandsverlauf der Komponenten der Strombegrenzungseinrichtung in Abhängigkeit von der Temperatur dargestellt. Der Nennbetrieb der Strombegrenzungseinrichtung erfolgt bei T_{N}, wobei bei dieser Temperatur gerade noch nicht die Shubnikov-Phase vorliegt, so dass das Schaltelement im supraleitenden Bereich betrieben wird. Der elektrische Widerstand des Schaltelementes ist vernachlässigbar gering, so dass der Strom komplett über das Schaltelement geführt ist und der Kommutierungsleiter bzw. das Bypasselement mit ihren um Größenordnungen höheren elektrischen Widerständen fasst stromlos sind.

Im Strombegrenzungsfall (Netzfehler wie z. B. Kurzschluss) steigt der geführte Strom sprunghaft an, wodurch im Supraleiter eine Induktion erzeugt wird. Dadurch gerät das Schaltelement an den Anfang des Flux-Flow-Bereiches und erfährt eine sprunghafte Erhöhung des Widerstandes. Damit geht ein Teil des Kurzschlussstromes in den Bypass und insbesondere auch in den Kommutierungsleiter über, wobei deren Widerstandswerte bei T_{N}, der Temperatur im Normalbetrieb genügend gering sein müssen, damit diese einen nennenswerten Teil der Kurzschlussstromes übernehmen. Durch den Strom im Kommutierungsleiter steigt auch dessen magnetische Induktion, die wiederum den Widerstand in dem Schaltelement erhöht, wobei der Flux-Flow-Bereich jedoch nicht verlassen werden darf (vgl. obere Grafik).

Bei dem beschriebenen Vorgang erwärmt sich das Schaltelement, wobei die Temperaturerhöhung gleichzeitig zu einer verstärkten Wärmeabgabe an das Kühlmittel des Kryostaten verbunden ist. Die Kühlleistung des Kryostaten reicht aus, damit sich während des Strombegrenzungsfalles bei der Temperatur T_{S} ein stationärer Zustand einstellt, bei dem die im Schaltelement erzeugte Wärme mit der an das Kühlmittel abgeführten Wärme im Gleichgewicht steht. Damit wird eine Erwärmung des Schaltelementes über T_{S} hinaus verhindert, so dass ein genügender Sicherheitsabstand zur kritischen Temperatur T_{C} eingehalten und das damit verbundene Quenchen des Supraleiters wirksam verhindert wird.

Der unteren Grafik in Figur 3 ist weiterhin zu entnehmen, dass die Widerstandserhöhung des Schaltelementes im Flux-Flow-Bereich wesentlich geringer ausfällt als die mit dem Quenchen des Supraleiters verbundene Widerstandserhöhung. Daher muss das erfindungsgemäße supraleitende Schaltelement in einer entsprechenden, den für die Strombegrenzung geforderten Widerstand erzeugenden Länge vorgesehen werden. Weiterhin ist zu erkennen, dass die Widerstandserhöhung im Flux-Flow-Bereich auch von der Stromdichte J im Schaltelement abhängig ist. So ist die Widerstansänderung bei der Stromdichte im Normalbetrieb J_{N} kleiner als bei der Stromdichte im Strombegrenzungsfall J_{S}, die sich aus dem geforderten Kurzschlussstrom unter Berücksichtigung der auf das Bypasselement (Kurve 27) und den Kommutierungsleiter (Kurve 28) entfallenden Stromanteile ergibt. Die Verteilung hängt von dem Verhältnis der Widerstände der Komponenten der Strombegrenzungseinrichtung bei der Temperatur im Strombegrenzungsfall T_{S} ab, die sich in der unteren Grafik der Figur 3 direkt ablesen lassen. Der Widerstand des Bypasselementes (Kurve 27) ist nicht von der Temperatur im Kryostaten abhängig, da das Bypasselement außerhalb des Kryostaten angeordnet ist. Der Widerstand des Kommutierungsleiters (Kurve 28) weist einen für Normalleiter typischen, temperaturabhängigen Verlauf auf, wobei für den Kommutierungsleiter ein Material gewählt wird, das bei T_{S} ein verhältnismäßig geringen Widerstand aufweist, welcher in der Nähe des Widerstandes des Schaltelementes bei T_{S} liegt. Hierdurch kann eine Reduzierung der Stromdichte im Schaltelement im Strombegrenzungsfall erreicht werden.

## Patentansprüche

1. Elektrische Strombegrenzungseinrichtung mit einem in einem Kryostaten (15) mit einem Kühlmittel (16) angeordneten supraleitenden Schaltelement (13), wobei das Schaltelement (13) im Strombegrenzungsfall bei Erreichen des geforderten Kurzschlussreststromes der Strombegrenzungseinrichtung in der Shubnikov-Phase vorliegt,
**dadurch gekennzeichnet,**
**dass** das Schaltelement (13) derart dimensioniert ist, dass sich im Strombegrenzungsfall ein Gleichgewicht zwischen der durch den Kurzschlussreststrom im Schaltelement (13) erzeugten Wärme und der durch das Kühlmittel (16) abgeführten Wärme einstellt.

2. Strombegrenzungseinrichtung nach Anspruch 1,
**dadurch gekennzeichnet,**
**dass** die Kühlleistung des Kryostaten derart dimensioniert ist, dass das Schaltelement während der gesamten Strombegrenzungszeit in einem Temperaturbereich gehalten werden kann, in dem dieser in der Shubnikov-Phase vorliegt.

3. Strombegrenzungseinrichtung nach Anspruch 1 oder 2,
**dadurch gekennzeichnet,**
**dass** das Schaltelement mit einer thermischen Isolationsschicht (22) versehen ist.

4. Strombegrenzungseinrichtung nach einem der vorangehenden Ansprüche,
**dadurch gekennzeichnet,**
**dass** das Schaltelement (13) einen Kommutierungsleiter (21) trägt, der parallel zum Schaltelement (13) verläuft.

5. Strombegrenzungseinrichtung nach einem der vorangehenden Ansprüche,
**dadurch gekennzeichnet,**
**dass** der Kommutierungsleiter (21) aus einem Metall oder einer Metalllegierung mit positiver magnetischer Suszeptibilität gebildet ist.

6. Strombegrenzungseinrichtung nach einem der voranstehenden Ansprüche,
**dadurch gekennzeichnet,**
**dass** das Schaltelement (13) spiralförmig im Kryostaten (15) verläuft.

7. Strombegrenzungseinrichtung nach einem der vorangehenden Ansprüche,
**dadurch gekennzeichnet,**
**dass** in Parallelschaltung zum Schaltelement ein Bypasselement (14) angeordnet ist.

8. Strombegrenzungseinrichtung nach Anspruch 7,
**dadurch gekennzeichnet,**
**dass** sich das Bypasselement (14) außerhalb des Kryostaten (15) befindet.

## Claims

1. Electrical current-limiting device having a superconducting switching element (13) which is arranged in a cryostat (15), having a coolant (16), with the switching element (13) being in the Shubnikov phase on reaching the required short-circuit residual current in the current-limiting device when the current is being limited,
**characterized**
**in that** the switching element (13) is designed in such a manner that there is an equilibrium when the current is being limited, between the heat that is produced by the short-circuit residual current in the switching element (13) and the heat which is dissipated by the coolant (16).

2. Current-limiting device according to claim 1,
**characterized**
**in that** the cooling power of the cryostat is designed in such a manner that the switching element can be kept in a temperature range in which it is in the Shubnikov phase throughout the entire current-limiting time.

3. Current-limiting device according to claim 1 or 2,
**characterized**
**in that** the switching element is provided with a thermal insulation layer (22).

4. Current-limiting device according to one of the preceding claims,
**characterized**
**in that** the switching element (13) is fitted with a commutation conductor (21), which runs parallel to the switching element (13).

5. Current-limiting device according to one of the preceding claims,
**characterized**
**in that** the commutation conductor (21) is formed from a metal or a metal alloy with positive magnetic susceptibility.

6. Current-limiting device according to one of the preceding claims,
**characterized**
**in that** the switching element (13) runs in a spiral shape in the cryostat (15).

7. Current-limiting device according to one of the preceding claims,
**characterized**
**in that** a bypass element (14) is arranged in parallel with the switching element.

8. Current-limiting device according to claim 7,
**characterized**
**in that** the bypass element (14) is located outside the cryostat.

## Revendications

1. Limiteur de courant électrique, ayant un élément (13) de commutation supraconducteur disposé dans un cryostat (15) ayant un fluide (16) de refroidissement, l'élément (13) de commutation se présentant, dans le cas de la limitation du courant, lorsque est atteint le courant résiduel de court-circuit exigé du limiteur de courant, dans la phase de Shubnikov,
**caractérisé**
**en ce que** les dimensions de l'élément (13) de commutation sont telles que, dans le cas de la limitation du courant, il s'établit un équilibre entre la chaleur produite par le courant résiduel de court-circuit dans l'élément (13) de commutation et la chaleur évacuée par le fluide (16) de refroidissement.

2. Limiteur de courant suivant la revendication 1,
**caractérisé**
**en ce que** la puissance de refroidissement du cryostat est telle que l'élément de commutation peut, pendant toute la durée de limitation du courant, être maintenue dans une plage de température dans laquelle il se présente dans la phase de Shubnikov.

3. Limiteur de courant suivant la revendication 1 ou 2,
**caractérisé**
**en ce que** l'élément de commutation est muni d'une couche (22) isolante du point de vue thermique.

4. Limiteur de courant suivant l'une des revendications précédentes,
**caractérisé**
**en ce que** l'élément (13) de commutation porte un conducteur (11) de commutation qui s'étend parallèlement à l'élément (13) de commutation.

5. Limiteur de courant suivant l'une des revendications précédentes,
**caractérisé**
**en ce que** le conducteur (21) de commutation est en métal ou en alliage métallique ayant une susceptibilité magnétique positive.

6. Limiteur de courant suivant l'une des revendications précédentes,
**caractérisé**
**en ce que** l'élément (13) de commutation s'étend en forme de spirale dans le cryostat (15).

7. Limiteur de courant suivant l'une des revendications précédentes,
**caractérisé**
**en ce qu'**un élément (14) de dérivation est monté en parallèle à l'élément de commutation.

8. Limiteur de courant suivant la revendication 7,
**caractérisé**
**en ce que** l'élément (14) de dérivation se trouve à l'extérieur du cryostat (15).
